# EUROPÄISCHE PATENTSCHRIFT

(11) **EP 0 508 267 B1**
(45) Veröffentlichungstag und Bekanntmachung des Hinweises auf die Patenterteilung: **14.06.1995**
(21) Anmeldenummer: 92105465.6
(22) Anmeldetag: 30.03.1992
(51) Int. Cl.: G03F 7/022

(54) **Strahlungsempfindliches Gemisch mit Estern der 1,2-Naphthochinon-2-diazid-sulfonsäure und ein damit hergestelltes strahlungsempfindliches Aufzeichnungsmaterial**
Radiation-sensitive composition with 1,2-naphthoquinone-2-dazide-sulfonic acid esters and recording material produced therewith
Composition sensible aux radiations contenant des esters d'acides 1,2-naphtoquinone-2 diazide sulfoniques et matériel d'enregistrement à base de cette composition

(30) Priorität: 09.04.1991 DE 4111445
(43) Veröffentlichungstag der Anmeldung: 14.10.1992
(73) Patentinhaber: HOECHST AKTIENGESELLSCHAFT, 65926 Frankfurt am Main (DE)
(72) Erfinder: Zahn, Wolfgang, Dr., W-6228 Eltville 2 (DE); Merrem, Hans-Joachim, Dr., Basking Ridge, New Jersey 07920 (DE); Erdmann, Fritz, Dr., W-6228 Eltville-Martinsthal (DE); Schmitt, Axel, Dr., W-6229 Walluf (DE)

(56) Entgegenhaltungen:
- EP-A- 0 055 814
- EP-A- 0 295 626
- PATENT ABSTRACTS OF JAPAN vol. 14, no. 329 (P-1076)16. Juli 1990

## Beschreibung

Die Erfindung betrifft ein strahlungsempfindliches Gemisch mit Estern der 1,2-Naphthochinon-2-diazid-4- und/oder -5-sulfonsäure mit mindestens zwei verschiedenen Hydroxybenzophenonen und ein damit hergestelltes strahlungsempfindliches Aufzeichnungsmaterial.

Wichtige Schritte bei der Herstellung von elektronischen Bauelementen sind die bildmäßige Belichtung und die nachfolgende Entwicklung von strahlungsempfindlichen Schichten, die auf dem zu strukturierenden Material aufgetragen sind.

Geeignete strahlungsempfindliche Schichten enthalten im allgemeinen ein wasserunlösliches, in wäßrig-alkalischen Lösungen lösliches oder zumindest quellbares, harzartiges Bindemittel und mindestens eine strahlungsempfindliche Verbindung sowie eventuell noch weitere Zusatzstoffe. Als photoaktive Komponenten werden bei positiv arbeitenden Schichten in den meisten Fällen Derivate von 1,2-Naphthochinon-2-diaziden eingesetzt.

Eine große Anzahl solcher Derivate, vor allem Ester von 1,2-Naphthochinon-2-diazid-sulfonsäuren mit aromatischen Hydroxyverbindungen, sind bereits bekannt und werden als strahlungsempfindliche Komponenten in positiv arbeitenden Aufzeichnungsmaterialien verwendet. In dem Buch von Jaromir Kosar: "Light-Sensitive Systems", John Wiley & Sons, New York, 1965, Seiten 343 bis 351, wird eine Reihe von strahlungsempfindlichen Naphthochinondiaziden beschrieben.

Häufig verwendet und vielfach beschrieben werden die Ester von Naphthochinondiazid-sulfonsäuren mit mehrfach hydroxylierten Benzophenonen, besonders mit 2,3,4-Trihydroxy-benzophenon und mit 2,3,4,4′-Tetrahydroxy-benzophenon.

Die fortschreitende Miniaturisierung von elektronischen Bauelementen erfordert die Erzeugung von immer kleineren Strukturen. Dafür werden strahlungsempfindliche Schichten, sogenannte Photoresists, mit immer höherem Auflösungsvermögen benötigt. Es ist bekannt, daß eine Erhöhung des Auflösungsvermögens durch Steigerung des Gehaltes an Diazochinon in der strahlungsempfindlichen Schicht (H. Münzel, J. Lux, R. Schulz : A- and B-Parameter Dependent Submicron Stepper Performance of Positive Type Photoresist; Microelectronic Engineering 6, 1987, Seiten 421-426) erreicht werden kann. Weiter ist bekannt, daß mehrfunktionelle Diazo-naphthochinone einen besseren Kontrast und eine bessere Auflösung bei Photoresists bewirken (P. Trefonas III, B. K. Daniels: New Principle for Image Enhancement in Single Layer Positive Photoresists; Proceedings of SPIE, 771, 1987, Seiten 194-210).

Von den mehrfunktionellen Diazonaphthochinonen sind die Tetraester aus 1,2-Naphthochinon-2-diazid-4- und -5-sulfonsäure mit 2,3,4,4′-Tetrahydroxy-benzophenon sehr gut als strahlungsempfindliche Komponente in positiv arbeitenden Photoresists geeignet. Die Konzentration dieser Verbindungen in den strahlungsempfindlichen Gemischen zur Steigerung des Auflösungsvermögens läßt sich jedoch wegen der relativ geringen Löslichkeit nur unzureichend erhöhen.

Nicht vollständig mit Naphthochinondiazid-sulfonsäure verestertes 2,3,4,4′-Tetrahydroxy-benzophenon stellt zwar je nach Veresterungsgrad ebenfalls eine geeignete strahlungsempfindliche Komponente für positiv arbeitende Photoresists dar, doch ist die Lagerstabilität dieser Photoresists stark begrenzt.

In den JP-A 01-222255, 01-49038 (1989) und 63-249143 (1988) sind bereits Wege zur Beseitigung dieser Nachteile beschrieben. Die Lagerstabilität der Resists wurde entweder durch eine besondere Reinigung der strahlungsempfindlichen Komponente oder durch Verwendung von Dimethylformamid als Lösemittel verbessert. Es ist jedoch wünschenswert, aufwendige Reinigungen zu vermeiden und nur Lösemittel zu verwenden, deren physikalische Kenndaten (Siedepunkt, etc.) die lithographischen Eigenschaften der Resists nicht verschlechtern und die toxisch absolut unbedenklich sind.

In der EP-A 0 295 626 ist ein strahlungsempfindliches Gemisch beschrieben, das neben einem Novolak als strahlungsempfindliche Komponente einen Ester aus 1,2-Naphthochinon-2-diazid-5-sulfonsäure und 2,3,4-Trihydroxybenzophenon einen Ester aus 1,2-Naphthochinon-2-diazid-5-sulfonsäure und 2,3,4,4′-Tetrahydroxy-benzophenon enthält. Es wird die Möglichkeit in Erwägung gezogen, daß auch ein Gemisch der beiden Ester geeignet sein könnte.

Das strahlungsempfindliche Gemisch gemäß der JP-A 02/109 051 enthält ein Novolak und ein Gemisch aus einem Ester aus 2,3,4-Trihydroxy-benzophenon und 1,2-Naphthochinon-2-diazid-5-sulfonsäure (Ester A, durchschnittlicher Veresterungsgrad mindestens 95%) sowie einem Ester aus 2,3,4,4′-Tetrahydroxy-benzophenon und 1,2-Naphthochinon-2-diazid-5-sulfonsäure (Ester B), wobei der Anteil von Ester (B) je 100 Gew.-% Ester (A) 1 bis 30 Gew.-% beträgt.

Aufgabe der vorliegenden Erfindung war es daher, ein strahlungsempfindliches Gemisch auf der Basis von Estern aus Hydroxybenzophenonen und 1,2-Naphthochinon-2-diazid-4- und/oder -5-sulfonsäure bereitzustellen, das mindestens ebenso gute lithographische Eigenschaften besitzt wie ein Gemisch, das mit einem Ester aus 2,3,4,4′-Tetrahydroxy-benzophenon und 1,2-Naphthochinon-2-diazid-4- oder -5-sulfonsäure hergestellt ist, ohne die Nachteile eines solchen Gemisches aufzuweisen.

Die Aufgabe wird überraschend gelöst mit einem strahlungsempfindlichen Gemisch, das neben einem nicht vollständig mit 1,2-Naphthochinon-2-diazid-4- und/ oder -5-sulfonsäure veresterten 2,3,4,4′-Tetrahydroxy-benzophenon zusätzlich entweder ein vollständig mit 1,2-Naphthochinon-2-diazid-4- und/oder -5-sulfonsäure verestertes Dihydroxybenzophenon oder ein teilweise oder vollständig mit 1,2-Naphthochinon-2-diazid-4- und/oder -5-sulfonsäure verestertes Trihydroxybenzophenon enthält.

Trihydroxybenzophenone sind gegenüber Dihydroxybenzophenonen bevorzugt; besonders bevorzugt ist das 2,3,4-Trihydroxy-benzophenon.

Der Veresterungsgrad wird so gewählt, daß das Veresterungsprodukt zu 80 bis 95 Gew.-%, bevorzugt 80 bis 90 Gew.-% aus dem Tetraester des 2,3,4,4′-Tetrahydroxy-benzophenons bzw. zu 70 bis 100 Gew.-%, bevorzugt 75 bis 95 Gew.-%, besonders bevorzugt 80 bis 90 Gew.-%, aus dem Triester des Trihydroxy-benzophenons besteht.

Der Triestergehalt kann auch durch Zumischen von entsprechend geringer verestertem Trihydroxybenzophenon zu reinem Triester eingestellt werden.

Das Gewichtsverhältnis des veresterten 2,3,4,4′-Tetrahydroxy-benzophenons zu dem bzw. den veresterten Di- oder Trihydroxybenzophenon(en) liegt zwischen 7 : 3 4,5 : 5,5 und 7 : 3.

In dem erfindungsgemäßen Gemisch können die veresterten Di-, Tri- und Tetrahydroxybenzophenone als 4-Sulfonylester, 5-Sulfonylester, 4- neben 5-Sulfonylester oder gemischte 4- und 5-Sulfonylester enthalten sein.

Hergestellt werden die Ester nach bekannten Verfahren, im allgemeinen durch Umsetzung der mehrfunktionellen Hydroxybenzophenone mit reaktiven Derivaten der Naphthochinondiazid-sulfonsäure, wie dem Sulfonylchlorid. Bevorzugt wird die Umsetzung in inerten Lösemitteln, wie Ketonen oder chlorierten Kohlenwasserstoffen, in Gegenwart von anorganischen oder organischen Basen, wie Natriumcarbonat oder tertiären Aminen, wie Triethylamin, ausgeführt. Die Naphthochinondiazid-sulfonsäureester können jedoch auch unter den Bedingungen der Phasen-Transfer-Katalyse, z. B. im System Methylenchlorid/Natriumcarbonat- oder Tetraalkylammoniumhydroxid-Lösung mit einem geeigneten Katalysator, wie Tetrabutylammoniumbromid, dargestellt werden.

Die Konzentration der Naphthochinondiazid-sulfonsäureestergemische in dem erfindungsgemäßen strahlungsempfindlichen Gemisch kann in relativ weiten Grenzen schwanken. Im allgemeinen liegt der Anteil bei 5 bis 40 Gew.-%, bevorzugt zwischen 10 und 35 Gew.-%, besonders bevorzugt zwischen 15 und 30 Gew.-%, bezogen auf das Gewicht des Feststoffanteils des Gemisches.

Strahlungsempfindliche Gemische enthalten ferner ein in Wasser unlösliches, in wäßrig-alkalischer Lösung dagegen lösliches oder zumindest quellbares polymeres Bindemittel.

Die in vielen positiv arbeitenden Aufzeichnungsmaterialien auf Basis von Naphthochinondiaziden bewährten Novolak-Kondensationsharze haben sich auch in den erfindungsgemäßen Gemischen als besonders brauchbar und vorteilhaft erwiesen. Die Novolake können mit Phenol, Kresol, Xylenol und/oder Trimethyl-phenol hergestellt sein. Die Kondensationspartner dieser phenolischen Komponenten sind Aldehyde und Ketone. Die Art und Menge der Novolak-Harze kann je nach Anwendungszweck verschieden sein. Im allgemeinen liegen die Novolak-Anteile zwischen 60 und 95 Gew.-%, bevorzugt zwischen 65 und 90 Gew.-%, besonders bevorzugt zwischen 70 und 85 Gew.-%, bezogen auf das Gewicht des Feststoffanteils des Gemisches.

Ebenfalls als Bindemittel geeignet sind polymere Verbindungen mit phenolischen Hydroxygruppen, wie Polymere mit Vinylphenol und Estern oder Amiden der Acrylsäure, und mit (Meth)acrylaten oder (Meth)acrylamiden von Di- und Polyhydroxy- und Aminohydroxyaromaten, wie Hydrochinon, Brenzkatechin, Resorcin, Pyrogallol oder Hydroxyanilin. Neben Homopolymeren können auch Copolymere der genannten Monomeren untereinander oder auch mit anderen polymerisierbaren Monomeren, wie Styrol, (Meth)acrylsäuremethylester und Bisphenol-(meth)acrylat, als Bindemittel in den erfindungsgemäßen Gemischen verwendet werden. Auch Mischungen dieser Polymere mit Novolaken sind einsetzbar. Art und Menge dieser Bindemittel ist je nach Anwendungszweck verschieden, liegt jedoch weitgehend in den für die Novolake angegebenen Bereichen.

Zur Einstellung spezieller Eigenschaften, wie Haftung, Glätte der Oberfläche, Absorptionsvermögen, kann das strahlungsempfindliche Gemisch noch weitere Substanzen, wie Netzmittel, Haftvermittler und Farbstoffe etc., in geringen Mengen enthalten.

Zur Herstellung des erfindungsgemäßen Aufzeichnungsmaterials werden die Gemische im allgemeinen in einem organischen Lösemittel gelöst und auf einen geeigneten Träger aufgebracht. Die Wahl des Lösemittels ist auf das vorgesehene Beschichtungsverfahren, die Schichtdicke und die Trocknungsbedingungen abzustimmen. Geeignete Lösemittel für das erfindungsgemäße Gemisch sind insbesondere Ketone, wie Butanon und N-Methylpyrrolidon, Alkandiol-mono-alkylether, wie Ethylenglykol-monomethylether und Propylenglykol-monomethyl- und -monoethylether, Alkandiol-ether-acetate, wie Ethylenglykol-monoethylether-acetat oder Propylenglykol-monoalkylether-acetate, und Ester, wie Butylacetat. Es können auch Gemische von Lösemitteln verwendet werden, die u. a. auch Xylol enthalten können. Prinzipiell sind alle Lösemittel verwendbar, die mit den Schichtkomponenten nicht irreversibel reagieren.

Das erfindungsgemäße strahlungsempfindliche Gemisch läßt sich insbesondere in Photoresists für die Mikroelektronik-Industrie verwenden. Bevorzugte Schichtträger sind hier Silicium-Scheiben, die auch oberflächlich oxidiert sein können. Die während der üblichen mikroelektronischen Fertigungsprozesse auftretenden Schichten, z. B. solche aus Siliciumnitrid, Polysilicium, Siliciumoxid, Polyimide oder Metalle, wie Aluminium, und auch dotiertes Silicium sind als Schichtträger für die erfindungsgemäßen Gemische ebenfalls geeignet. Auch Scheiben aus Ga/As-Legierungen stellen geeignete Schichtträger dar. Weiterhin können die erfindungsgemäßen Gemische in der Leiterplattenfertigung verwendet werden, wobei die hierfür üblichen Schichtträger Verwendung finden.

Schließlich lassen sich mit dem erfindungsgemäßen Gemisch auch Druckplatten herstellen. Schichtträger sind hier in erster Linie vorbehandelte Aluminiumplatten.

Die Beschichtung der in der Mikroelektronik-Industrie üblichen Schichtträger erfolgt gewöhnlich durch Aufschleudern. Für diese und andere Schichtträger kommen jedoch auch Beschichtungstechniken wie Sprühen, Walzen, Tauchen, Beschichten mittels Breitschlitzdüsen, Rakeln oder durch Gießer-Antrag in Betracht.

Die zum Entwickeln verwendeten wäßrig-alkalischen Lösungen entfernen die vom Licht getroffenen Stellen der strahlungsempfindlichen Schicht und erzeugen so ein positives Abbild der Vorlage. Geeignete Entwickler sind wäßrig-alkalische Lösungen, die metallionenfrei sein, aber auch Metallionen, wie Natrium- und/oder Kaliumionen, enthalten können. Die Entwicklerlösungen können gepuffert sein, zum Beispiel mit Silikat-, Borat- oder Phosphatlösungen oder Mischungen von Salzlösungen, und auch geringe Mengen von Tensiden enthalten.

Bevorzugte Anwendung finden die erfindungsgemäßen strahlungsempfindlichen Gemische bei lithographischen Prozessen bei der Herstellung von integrierten Schaltungen oder von diskreten Bauelementen. Sie dienen dabei als Maskierungsmaterial für verschiedene Prozeßschritte, wie zum Beispiel Ätzen des Schichtträgers, Implantation von Ionen in den Schichtträger oder Abscheidung von Materialien auf dem Schichtträger.

Wichtige lithographische Beurteilungskriterien sind u. a. die Auflösung eines Resists (d. h. die kleinsten Strukturen, die mit einem Resist noch erzeugt werden können), der Verarbeitungsspielraum (d. h. die Änderung der Strukturdimensionen bei Änderung der Belichtungsenergie) und die Strahlungsempfindlichkeit (d. h. die Belichtungsenergie, die notwendig ist, um die Strukturen der Maskenvorlage durch den lithographischen Prozeß dimensionsgetreu im Resist wiederzugeben). Für eine reproduzierbare Verarbeitung der Resists ist es weiter wesentlich, daß sich zum einen die lithographischen Kennwerte während der Lagerung des Resists nicht verändern und zum anderen während der Lagerung auch keine Partikel (Kristalle oder Gelteilchen) aus dem Resist ausscheiden, die die Gleichmäßigkeit der Resistschicht stören würden. Derartige Partikel führen zu Fehlstellen in der Resistschicht, was eine Verringerung der Ausbeute bei dem lithographischen Prozeß zur Folge hat. Außerdem bewirken solche Partikel in den Filtern der Pumpen, die den Resist zu der Beschichtungsmaschine transportieren, häufig Verstopfungen, was einen vermehrten Filterwechsel zur Folge hat.

Die erfindungsgemäßen Diazogemische verleihen Photoresists zumindest gleich gute lithographische Eigenschaften wie Naphthochinondiazidsulfonsäureester mit 2,3,4,4′-Tetrahydroxy-benzophenon als alleiniger Hydroxy-Komponente, verbessern jedoch die Strahlungsempfindlichkeit und vor allem die Lagerstabilität der Photoresists deutlich.

Im folgenden werden Beispiele der erfindungsgemäßen strahlungsempfindlichen Gemische genannt, wobei der Erfindungsgedanke jedoch nicht auf die Beispiele beschränkt ist. Gt steht im folgenden für Gewichtsteile.

### Beispiel 1

Es wird eine Lösung eines strahlungsempfindlichen Gemisches hergestellt aus
- 73,0 Gt: Propylenglykol-monomethylether-acetat,
- 20,8 Gt: Novolak,
- 3,2 Gt: Veresterungsprodukt aus 2,3,4,4′-Tetrahydroxybenzophenon und 1,2-Naphthochinon-2-diazid-5-sulfonsäure, das zu 88 Gew.-% aus dem Tetraester besteht, und
- 3,2 Gt: 2,3,4-Trihydroxy-benzophenon, dessen Hydroxygruppen vollständig mit 1,2-Naphthochinon-2-diazid-5-sulfonsäure verestert sind.

Diese Lösung wird so auf eine Siliciumscheibe aufgeschleudert, daß nach dem Trocknen auf einer Heizplatte bei 90 °C eine Schichtdicke von 1,2 »m erhalten wird.

Anschließend belichtet man mit einem in der Technik üblichen Belichtungsgerät (einem sog. Stepper, der eine Belichtungswellenlänge von 436 nm und eine numerische Apertur von 0,35 besitzt) durch eine Maske. Nach einer weiteren thermischen Behandlung auf einer Heizplatte wird die beschichtete Siliciumscheibe 30 s lang in einen Entwickler getaucht, wobei die von Licht getroffenen Stellen des Resists entfernt werden. Durch diesen Prozeß können mit dem erfindungsgemäßen strahlungsempfindlichen Gemisch Strukturen mit Dimensionen bis herab zu 0,70 »m (bei dimensionsgetreuer Wiedergabe auch der größeren Strukturen) erzeugt werden, wofür eine Belichtungsenergie von nur 240 mJ/cm² notwendig ist.

Das erfindungsgemäße strahlungsempfindliche Gemisch ist bei 50 °C mindestens 10 Tage stabil, ohne daß Partikel aus der Resistlösung ausfallen.

### Beispiel 2

Beispiel 1 wird wiederholt mit der Änderung, daß die dort genannten Ester ersetzt sind durch
- 3,2 Gt: Veresterungsprodukt aus 2,3,4,4′-Tetrahydroxy-benzophenon und 1,2-Naphthochinon-2-diazid-5-sulfonsäure, das zu 85 Gew.-% aus dem Tetraester besteht, und
- 3,2 Gt: Veresterungsprodukt aus 2,3,4-Trihydroxybenzophenon und 1,2-Naphthochinon-2-diazid-5-sulfonsäure, das zu 90 Gew.-% aus dem Triester besteht.

Ansonsten wird gemäß Beispiel 1 verfahren. Es können Strukturen mit Dimensionen bis herab zu 0,70 »m (bei dimensionsgetreuer Wiedergabe auch der größeren Strukturen) erzeugt werden, bei einer notwendigen Belichtungsenergie von 250 mJ/cm². Die Belichtungsenergie kann um 25 % variiert werden, ohne daß sich die Breite der 0,80-»m-Linien um mehr als das allgemein akzeptierte Maß von 10 % ändert.

Die erfindungsgemäße Resistlösung ist bei 50 °C mindestens 6 Tage stabil, ohne daß Partikel aus der Lösung ausfallen.

### Beispiel 3

Beispiel 1 wird wiederholt mit der Änderung, daß die dort genannten Ester ersetzt sind durch
- 3,2 Gt: Veresterungsprodukt aus 2,3,4,4′-Tetrahydroxy-benzophenon und 1,2-Naphthochinon-2-diazid-5-sulfonsäure, das zu 85 Gew.-% aus dem Tetraester besteht,
- 1,92 Gt: 2,3,4-Trihydroxy-benzophenon, dessen Hydroxygruppen vollständig mit 1,2-Naphthochinon-2-diazid-5-sulfonsäure verestert sind, und
- 1,28 Gt: Veresterungsprodukt aus 2,3,4-Trihydroxybenzophenon und 1,2-Naphthochinon-2-diazid-5-sulfonsäure, das zu 40 Gew.-% aus dem Triester besteht.

Ansonsten wird gemäß Beispiel 1 verfahren. Es können Strukturen mit Dimensionen bis herab zu 0,70 »m (bei dimensionsgetreuer Wiedergabe auch der größeren Strukturen) erzeugt werden, bei einer notwendigen Belichtungsenergie von 220 mJ/cm². Die Belichtungsenergie kann um 22 % variiert werden, ohne daß sich die Breite der 0,80-»m-Linien um mehr als das allgemein akzeptierte Maß von 10 % ändert.

Die erfindungsgemäße Resistlösung ist bei 50 °C mindestens 6 Tage stabil, ohne daß Partikel aus der Lösung ausfallen.

### Vergleichsbeispiel

Beispiel 1 wird wiederholt mit der Änderung, daß die dort genannten Ester ersetzt sind durch
- 6,4 Gt: Veresterungsprodukt aus 2,3,4,4′-Tetrahydroxy-benzophenon und 1,2-Naphthochinon-2-diazid-5-sulfonsäure, das zu 85 Gew.-% aus dem Tetraester besteht.

Ansonsten wird gemäß Beispiel 1 verfahren. Es können Strukturen mit Dimensionen bis herab zu 0,70 »m (bei dimensionsgetreuer Wiedergabe auch der größeren Strukturen) erzeugt werden, bei einer notwendigen Belichtungsenergie von 300 mJ/cm². Die Belichtungsenergie kann um 28 % variiert werden, ohne daß sich die Breite der 0,80-»m-Linien um mehr als das allgemein akzeptierte Maß von 10 % ändert.

Die Resistlösung ist bei 50 °C nur 2 Tage stabil, ohne daß Partikel aus der Lösung ausfallen.

## Patentansprüche

1. Strahlungsempfindliches Gemisch mit einem in Wasser unlöslichen, in wäßrig-alkalischer Lösung dagegen löslichen oder zumindest quellbaren polymeren Bindemittel und einem mit 1,2-Naphthochinon-2-diazid-4- und/oder -5-sulfonsäure teilweise veresterten 2,3,4,4′-Tetrahydroxy-benzophenon, dadurch gekennzeichnet, daß es zusätzlich entweder ein vollständig mit 1,2-Naphthochinon-2-diazid-4- und/oder -5-sulfonsäure verestertes Dihydroxybenzophenon oder ein teilweise oder vollständig mit 1,2-Naphthochinon-2-diazid-4- und/oder -5-sulfonsäure verestertes Trihydroxybenzophenon enthält, wobei das Gewichtsverhältnis von verestertem 2,3,4,4′-Tetrahydroxy-benzophenon zu verestertem Di- oder Trihydroxybenzophenon 4,5 : 5,5 bis 7 : 3 beträgt, das Veresterungsprodukt des 2,3,4,4′-Tetrahydroxybenzophenons zu 80 bis 95 Gew.-% aus dem Tetraester besteht und die veresterten Hydroxybenzophenone insgesamt einen Anteil von 5 bis 40 Gew.-%, bezogen auf das Gesamtgewicht der Feststoffe im Gemisch, haben.

2. Strahlungsempfindliches Gemisch gemäß Anspruch 1, dadurch gekennzeichnet, daß das Veresterungsprodukt des 2,3,4,4′-Tetrahydroxy-benzophenons zu 80 bis 90 Gew.-% aus dem Tetraester und das Veresterungsprodukt des Trihydroxybenzophenons zu 70 bis 100 Gew.-%, bevorzugt zu 75 bis 95 Gew.-%, besonders bevorzugt zu 80 bis 90 Gew.-%, aus dem Triester besteht, jeweils bezogen auf das Gesamtgewicht.

3. Strahlungsempfindliches Gemisch gemäß Anspruch 1 oder 2, dadurch gekennzeichnet, daß das Gewichtsverhältnis von verestertem 2,3,4,4′-Tetrahydroxy-benzophenon zu verestertem Di- oder Trihydroxybenzophenon 4,5 : 5,5 bis 5,5 : 4,5 beträgt.

4. Strahlungsempfindliches Aufzeichnungsmaterial bestehend aus einem Träger und einer darauf befindlichen strahlungsempfindlichen Schicht, dadurch gekennzeichnet, daß die Schicht ein strahlungsempfindliches Gemisch gemäß einem oder mehreren der Ansprüche 1 bis 3 enthält.

## Claims

1. Radiation-sensitive composition comprising a polymeric binder which is insoluble in water, but soluble or at least swellable in aqueous-alkaline solution and a 2,3,4,4′-tetrahydroxybenzophenone which is partially esterified with (1,2-naphthoquinone 2-diazide)-4- and/or -5-sulfonic acid, characterized in that it additionally contains, either a dihydroxybenzophenone which is completely esterified with (1,2-naphthoquinone 2-diazide)-4- and/or -5-sulfonic acid or a trihydroxybenzophenone which is partially or completely esterified with (1,2-naphthoquinone 2-diazide)-4-and/or -5-sulfonic acid, the weight ratio of esterified 2,3,4,4′-tetrahydroxybenzophenone to esterified di- or trihydroxybenzophenone varying between 4,5:5,5 and 7:3, the esterification product of the 2,3,4,4′-tetrahydroxybenzophenone has a content of 80 to 95 % by weight of the tetraester, and the esterified hydroxybenzophenones, as a whole, are present in a proportion of 5 to 40 % by weight, based on the total weight of solids contained in the composition.

2. The radiation-sensitive composition as claimed in claim 1, wherein the esterification product of the 2,3,4,4′-tetrahydroxybenzophenone has a content of 80 to 90 % by weight of the tetraester, and the esterification product of the trihydroxybenzophenone has a content of 70 to 100 % by weight, preferably 75 to 95 % by weight, particularly preferably of 80 to 90 % by weight of the triester, based on the total weight.

3. The radiation-sensitive composition as claimed in claim 1 or 2, wherein the weight of ratio of esterified 2,3,4,4′-tetrahydroxybenzophenone to esterified di- or trihydroxybenzophenone varies between 4.5:5.5 and 5.5:4.5.

4. Radiation-sensitive recording material comprising a support and a radiation-sensitive layer which is applied to the support, wheren the layer contains a radiation-sensitive composition as claimed in any one or several of claims 1 to 3.

## Revendications

1. Composition sensible aux radiations qui comporte un liant polymère, insoluble dans l'eau mais soluble ou au moins gonflable en solution alcaline aqueuse, et une 2,3,4,4′-tétrahydroxybenzophénone partiellement estérifiée par un (des) acide(s) 1,2-naphtoquinone-2-diazide-4- et/ou -5-sulfonique(s), caractérisée en ce qu'elle contient en plus soit une dihydroxybenzophénone complètement estérifiée par un (des) acide(s) 1,2-naphtoquinone-2-diazide-4- ou -5-sulfonique(s), soit une trihydroxybenzophénone estérifiée partiellement ou complètement par un (des) acide(s) 1,2-naphtoquinone-2-diazide-4- ou -5-sulfonique(s), le rapport pondéral de la 2,3,4,4′-tétrahydroxybenzophénone estérifiée à la di- ou trihydroxybenzophénone estérifiée étant de 4,5:5,5 à 7:3, le degré d'estérification étant choisi de telle sorte que le produit d'estérification de la 2,3,4,4′-tétrahydroxybenzophénone se compose du tétraester à raison de 80 à 95 % en poids et les hydroxybenzophénones estérifiées représentent au total une proportion de 5 à 40 % en poids par rapport au poids total de solides dans la composition.

2. Composition sensible aux radiations selon la revendication 1, caractérisée en ce que le produit d'estérification de la 2,3,4,4′-tétrahydroxybenzophénone se compose du tétraester à raison de 80 à 90 % en poids et le produit d'estérification de la 2,3,4-trihydroxybenzophénone se compose du triester à raison de 70 à 100 % en poids, de préférence 75 à 95 % en poids, encore mieux 80 à 90 % en poids, chaque fois par rapport au poids total.

3. Composition sensible aux radiations selon la revendication 1 ou 2, caractérisée en ce que le rapport pondéral de la 2,3,4,4′-tétrahydroxybenzophénone estérifiée à la di- ou trihydroxybenzophénone estérifiée est de 4,5:5,5 à 5,5:4,5.

4. Matériel d'enregistrement sensible aux radiations, comprenant un support et une couche sensible aux radiations déposée sur ce support, caractérisé en ce que la couche contient une composition sensible aux radiations selon une ou plusieurs des revendications 1 à 3.
